(19) Europäisches Patentamt
European Patent Office
Office européen des brevets

(11) **EP 4 768 970 A1**

(12) **EUROPEAN PATENT APPLICATION**
published in accordance with Art. 153(4) EPC

(43) Date of publication:
**01.07.2026 Bulletin 2026/27**

(21) Application number: **24925015.0**

(22) Date of filing: **29.11.2024**

(51) International Patent Classification (IPC):
*G01R 31/396* (2019.01)  *G01R 31/3835* (2019.01)
*G01R 31/392* (2019.01)  *G01R 31/367* (2019.01)
*G01R 19/165* (2006.01)

(52) Cooperative Patent Classification (CPC):
**G01R 19/165; G01R 31/367; G01R 31/3835;
G01R 31/392; G01R 31/396;** Y02E 60/10

(86) International application number:
**PCT/KR2024/019359**

(87) International publication number:
**WO 2025/173873 (21.08.2025 Gazette 2025/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.02.2024 KR 20240021752**

(71) Applicant: **LG Energy Solution, Ltd.
Seoul 07335 (KR)**

(72) Inventor: **JANG, Jin Woo
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS AND OPERATION METHOD THEREOF**

(57) A battery management apparatus according to an embodiment disclosed herein includes a voltage obtaining unit configured to obtain voltage data of each of a plurality of battery cells over time and a controller configured to calculate a first value regarding a voltage behavior of each of the plurality of battery cells in each of a plurality of cycles based on the voltage data obtained in the plurality of cycles, calculate a second value through normalization of the first values in each of the plurality of cycles, calculate time-series data of the second value of each of the plurality of battery cells for the plurality of cycles, and analyze a trend of time-series data of the plurality of battery cells to detect an abnormal battery cell.

FIG.1

EP 4 768 970 A1

## Description

## Technical Field

CROSS-REFERENCE TO RELATED APPLICATION

This application claims priority to and the benefit of Korean Patent Application No. 10-2024-0021752 filed in the Korean Intellectual Property Office on February 15, 2024, the entire content of which is incorporated herein by reference.

TECHNICAL FIELD

Embodiments disclosed herein relate to a battery management apparatus and an operating method thereof.

## Background Art

Recently, research and development of secondary batteries have been actively performed. Herein, the secondary batteries, which are chargeable/-dischargeable batteries, may be interpreted as including all of conventional nickel (Ni)/cadmium (Cd) batteries, Ni/metal hydride (MH) batteries, etc., and recent lithium-ion batteries. Recently, the lithium-ion battery is attracting attention as a next-generation energy storage medium as a usage range thereof is expanded to a power source of electric vehicles.

An electric vehicle is supplied with electricity from outside to charge a battery cell/module, and then the battery cell/module is discharged to drive a motor and obtain power. The battery cell/module undergoes internal deformation and denaturation through various charges/-discharges in production and use phases, such that physical and chemical characteristics thereof change. A technique for diagnosing and managing operations of the battery cell/module due to degradation and deterioration of a battery is required.

For various purposes such as performance diagnosis, state analysis, etc., of the battery, a charging/-discharging test may be conducted on the battery. For example, a test voltage may be applied to the battery, and a test result voltage may be measured from the battery in response to the test voltage. However, when a battery is diagnosed by applying a conventional technique for diagnosing the battery based on an instant abnormal voltage behavior to a long-term voltage behavior, the accuracy of diagnosis of an abnormal battery may be degraded. Thus, there is a need for a technique for analyzing a long-term voltage behavior and an abnormal voltage behavior.

## Disclosure

## Technical Problem

Embodiments disclosed herein aim to provide a battery management apparatus and an operating method thereof in which an abnormal battery cell may be managed based on voltage data obtained from a plurality of battery cells included in a battery pack.

Embodiments disclosed herein aim to provide a battery management apparatus and an operating method thereof based on a data processing algorithm for analyzing a long-term behavior of voltage data.

Technical problems of the embodiments disclosed herein are not limited to the above-described technical problems, and other unmentioned technical problems would be clearly understood by one of ordinary skill in the art from the following description.

## Technical Solution

A battery management apparatus according to an embodiment disclosed herein includes a voltage obtaining unit configured to obtain voltage data of each of a plurality of battery cells over time and a controller configured to calculate a first value regarding a voltage behavior of each of the plurality of battery cells in each of a plurality of cycles based on the voltage data obtained in the plurality of cycles, calculate a second value through normalization of the first values in each of the plurality of cycles, calculate time-series data of the second value of each of the plurality of battery cells for the plurality of cycles, and analyze a trend of time-series data of the plurality of battery cells to detect an abnormal battery cell.

According to an embodiment, each of the plurality of cycles may include a period between a charging start point and a discharging start point of the plurality of battery cells.

According to an embodiment, the controller may be further configured to calculate a first vector, a second vector, and a third vector indicating a voltage behavior between two different points among a charging start point, a charging end point, and a discharging start point of each of the plurality of battery cells and calculate the first value, which is a scalar value, by preprocessing the first vector, the second vector, and the third vector.

According to an embodiment, a start point of the first vector may be the charging start point and an end point of the first vector is the charging end point, a start point of the second vector may be the charging start point and an end point of the second vector is the discharging start point, and a start point of the third vector may be the charging end point and an end point of the third vector is the discharging start point.

According to an embodiment, the controller may be further configured to calculate a projection vector by projecting the first vector to the second vector, calculate a perpendicular vector that is a difference between the first vector and the projection vector, and calculate the first value that is a size of a vector calculated by projecting the third vector to the perpendicular vector.

According to an embodiment, the controller may be further configured to calculate the second value by normalizing the first value based on an average and a standard deviation of the first values in each of the plurality of cycles.

According to an embodiment, the controller may be further configured to decompose time-series data of the second value of each of the plurality of battery cells into a trend component and a remaining component based on at least one of a Hodrick-Prescott (HP) filter and a Baxter-King (BK) filter.

According to an embodiment, the controller may be further configured to detect the abnormal battery cell based on a magnitude of the remaining component of each of the plurality of battery cells.

According to an embodiment, the controller may be further configured to compare a magnitude of the remaining component with a first threshold value and detect a battery cell corresponding to the remaining component as an abnormal battery cell when the magnitude of the remaining component exceeds the first threshold value.

An operating method of a battery management apparatus according to an embodiment includes obtaining voltage data of each of a plurality of battery cells over time, calculating a first value regarding a voltage behavior of each of the plurality of battery cells in each of a plurality of cycles based on the voltage data obtained in the plurality of cycles, calculating a second value through normalization of the first values in each of the plurality of cycles, calculating time-series data of the second value of each of the plurality of battery cells for the plurality of cycles, and analyzing a trend of time-series data of the plurality of battery cells to detect an abnormal battery cell.

According to an embodiment, each of the plurality of cycles may include a period between a charging start point and a discharging start point of the plurality of battery cells.

According to an embodiment, the calculating of the first value may include calculating a first vector, a second vector, and a third vector indicating a voltage behavior between two different points among a charging start point, a charging end point, and a discharging start point of each of the plurality of battery cells and calculating the first value, which is a scalar value, by preprocessing the first vector, the second vector, and the third vector.

According to an embodiment, a start point of the first vector may be the charging start point and an end point of the first vector is the charging end point, a start point of the second vector may be the charging start point and an end point of the second vector is the discharging start point, and a start point of the third vector may be the charging end point and an end point of the third vector is the discharging start point.

According to an embodiment, the preprocessing may include calculating a projection vector by projecting the first vector to the second vector, calculating a perpendicular vector that is a difference between the first vector and the projection vector, and calculating the first value that is a size of a vector calculated by projecting the third vector to the perpendicular vector.

According to an embodiment, the calculating of the second value may include calculating the second value by normalizing the first value based on an average and a standard deviation of the first values in each of the plurality of cycles.

According to an embodiment, the analyzing of the trend of the time-series data of the plurality of battery cells may include decomposing time-series data of the second value of each of the plurality of battery cells into a trend component and a remaining component based on at least one of a Hodrick-Prescott (HP) filter and a Baxter-King (BK) filter.

According to an embodiment, the detecting of the abnormal battery cell may include detecting the abnormal battery cell based on a magnitude of the remaining component of each of the plurality of battery cells.

According to an embodiment, the detecting of the abnormal battery cell may include comparing a magnitude of the remaining component with a first threshold value and detecting a battery cell corresponding to the remaining component as an abnormal battery cell when the magnitude of the remaining component exceeds the first threshold value.

**Advantageous Effects**

A battery diagnosis apparatus and an operating method thereof disclosed herein may manage an abnormal battery cell based on voltage data obtained from a plurality of battery cells included in a battery pack.

In addition, various effects identified directly or indirectly through this document may be provided.

**Description of Drawings**

FIG. 1 shows a battery pack according to an embodiment disclosed herein.

FIG. 2 is a block diagram of a battery management apparatus according to an embodiment disclosed herein.

FIG. 3 is a graph showing a voltage of a battery cell according to an embodiment disclosed herein.

FIG. 4 is a graph showing a process of calculating a first value according to an embodiment disclosed herein.

FIG. 5 is a view showing time-series data of a second value according to an embodiment disclosed herein.

FIG. 6 is a graph showing a result of analyzing a trend of time-series data of a second value according to an embodiment disclosed herein.

FIG. 7 is a flowchart showing an operation of a battery management apparatus according to an embodiment disclosed herein.

FIG. 8 is a block diagram showing a hardware configuration of a computing system for performing an operating method of a battery management apparatus, according to an embodiment disclosed herein.

## Mode for Invention

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments of the disclosure, operations performed by a module, a program, or other components may be executed sequentially, in parallel, repeatedly, or heuristically, or one or more of the operations may be executed in a different order or omitted, or one or more other operations may be added.

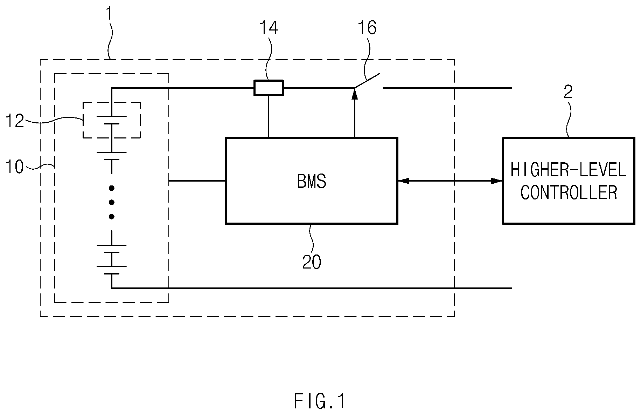

FIG. 1 shows a battery pack according to an embodiment disclosed herein. FIG. 1 schematically shows a battery control system including a battery pack 1 and a higher-level controller 2 included in a higher-level system, according to an embodiment of the present disclosure.

Referring to FIG. 1, the battery pack 1 may include a plurality of battery cells 10, a sensor unit 14, a switching unit 16, and a battery management system (BMS) 20. The battery pack 1 may include the plurality of battery cells 10, the sensor unit 14, the switching unit 16, and the BMS 20 provided in plural.

According to an embodiment, the plurality of battery cells 10 may supply power to a target device (not shown). To this end, the plurality of battery cells 10 may be electrically connected to the target device. Herein, the target device may include an electrical, electronic, or mechanical device that operates by receiving power from the battery pack 1. For example, the target device may be, but not limited to, an electric vehicle (EV) or an energy storage system (ESS).

According to an embodiment, the plurality of battery cells 10 may include at least one battery cell 12 that is chargeable and dischargeable. Herein, the battery cell 12 may be a basic unit of a battery cell available through charging/discharging of electric energy. For example, the battery cell 12 may be, but not limited to, a lithium ion (Li-ion) battery, an Li-ion polymer battery, a nickel-cadmium (Ni-Cd) battery, a nickel hydrogen (Ni-MH) battery, etc.

According to an embodiment, the plurality of battery cells 10 may be connected in series or in parallel. For example, the plurality of battery cells 10 may be a set of battery modules, battery banks, or battery cells (cell-to-pack structure). According to an embodiment, the plurality of battery cells 10 may include a first battery cell cell1, a second battery cell cell2, ..., an N-th battery cell cellN, and N may be an integer of at least 2.

According to an embodiment, the sensor unit 14 may obtain information related to the plurality of battery cells 10. For example, the sensor unit 14 may obtain values (or information) related to a state of each of the plurality of battery cells 10. In an embodiment, the values related to the state may include one or more values of voltage, current, resistance, state of charge (SOC), state of health (SOH), or temperature of the battery cell 12 or a combination thereof.

According to an embodiment, the sensor unit 14 may provide information about each of the plurality of battery cells 10 to the BMS 20.

According to an embodiment, the switching unit 16 may switch connection between the battery pack 1 and an external device. For example, the switching unit 16 may switch electrical connection between other components (e.g., the plurality of battery cells 10, the battery cell 12, the sensor unit 14, and the BMS 20) for the connection between the battery pack 1 and the external device.

According to an embodiment, the switching unit 16 may include an element for controlling a current flow for charging or discharging of the plurality of battery cells 10. For example, the switching unit 16 may include at least one relay and/or a magnetic contactor, etc., depending on the specification of the battery pack 1.

According to an embodiment, the BMS 20 may control or manage the battery pack 1 to prevent overcharging, overdischarging, etc., by monitoring voltage, current, temperature, etc., of the battery pack 1. For example, the BMS 20, which is an interface for receiving measurement values of the above-described various parameters, may include a plurality of terminals and a circuit, etc., connected thereto to process input values. The BMS 20 may control the sensor unit 14 and/or the switching unit 16. For example, the BMS 20 may be connected to the plurality of battery cells 10 to monitor a state of each of the plurality of battery cells 10 and control ON/OFF of a relay, a contactor, etc.

According to an embodiment, an operation of the BMS 20 may also be performed in various devices such as not only a BMS in a vehicle, but also a server, a cloud, a charger, a charger/discharger, etc.

The higher-level controller 2 may transmit a control signal regarding the plurality of battery cells 10 to the BMS 20. Thus, the BMS 20 may be controlled in terms of an operation thereof based on a signal applied from the higher-level controller 2.

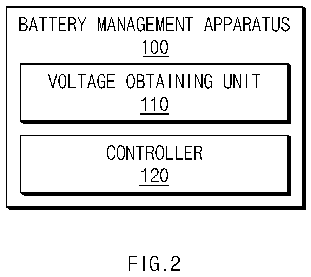

According to an embodiment, the BMS 20 may include a battery management apparatus 100 of FIG. 2 (see FIG. 2). According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a BMS in a vehicle, but also a server, a cloud, a charger, a charger/discharger, etc.

The higher-level controller 2 may transmit a control signal regarding the plurality of battery cells 10 to the battery management system 20. Thus, the battery management system 20 may be controlled in terms of an operation thereof based on a signal applied from the higher-level controller 2.

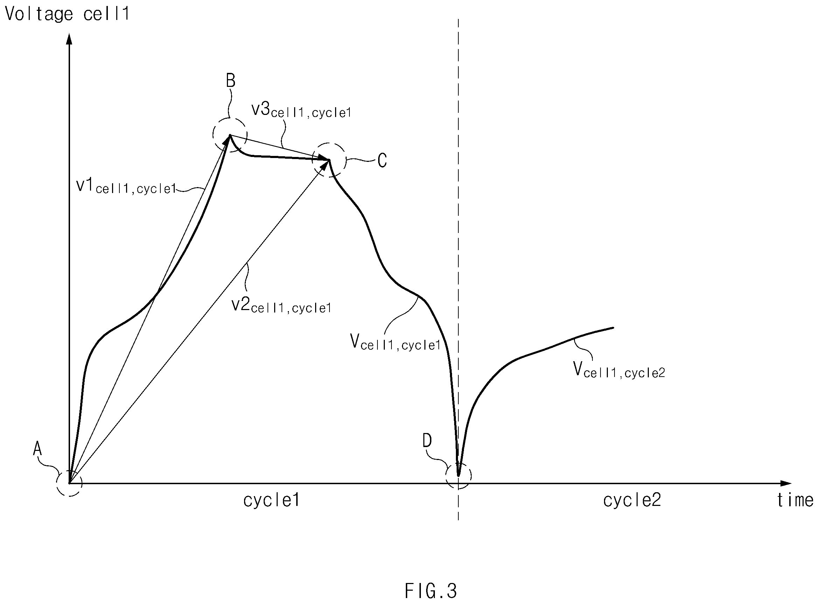

FIG. 2 is a block diagram of a battery management apparatus according to an embodiment disclosed herein. FIG. 3 is a graph showing a voltage of a battery cell according to an embodiment disclosed herein. The operation of the battery management apparatus 100 shown in FIG. 2 will be described below in detail with reference to FIGS. 3 to 6.

Referring to FIG. 2, the battery management apparatus 100 may manage a state of each of the plurality of battery cells 10 (see FIG. 1). The plurality of battery cells 10 may have a capacity decreasing and an internal resistance increasing as a period of use or the number of uses increases. The battery management apparatus 100 may diagnose internal abnormality of the plurality of battery cells 10 based on data of states changing with deterioration of the battery cells 10.

According to various embodiments, when abnormality occurs in a battery cell due to various causes such as a defect in a production stage of the battery cell, internal deformation and degeneration through charging/discharging, an external shock, etc., a voltage of the battery cell may more quickly and significantly change than a normal battery cell. Herein, a voltage behavior of a battery cell may include information related to a resistance or a capacity of the battery cell, and may include information about a state of the battery cell. Thus, when abnormality such as lithium precipitation, disconnection, a short-circuit, etc., occurs in the battery cell, a voltage of the battery cell in an abnormal state may show an aspect that is different from a normal battery cell.

According to various embodiments, the battery management apparatus 100 may detect abnormality of the battery cell based on a voltage behavior of the battery cell. Herein, the voltage behavior of the battery cell may mean a voltage variance of the battery cell over time. However, conventional techniques may detect an abnormal voltage change occurring for a short time or detect an abnormal voltage change based on a voltage in a discharging period of a battery and a voltage in a rest period after discharging.

On the other hand, the battery management apparatus 100 according to an embodiment may detect abnormality of the battery cell based on a long-term voltage behavior of the battery cell. Herein, the long-term voltage behavior may mean a trend of a voltage behavior of the battery cell during a plurality of charging/discharging cycles. In this way, the battery management apparatus 100 may detect an abnormal voltage behavior based on the trend of the long-term voltage behavior and detect an abnormal battery cell.

The battery management apparatus 100 according to an embodiment may detect abnormality of the battery cell based on a voltage in the charging period and the voltage in the rest period after the charging period. In this way, the battery management apparatus 100 may detect an abnormal behavior of a voltage, related to a capacity change of a battery cell, in the charging period and the rest period after the charging period and detect an abnormal battery cell.

According to an embodiment, the data obtaining unit 110 may obtain the voltage of each of the plurality of battery cells 10. That is, the information obtaining unit 110 may obtain the voltage of each of the plurality of battery cells 10 for each unit time. According to an embodiment, the information obtaining unit 110 may continuously obtain voltage data in the charging period, the rest period after charging, the discharging period, and/or the rest period after discharging of the plurality of battery cells 10 over time. According to an embodiment, the voltage obtaining unit 110 may include a voltage monitoring circuit or sensor.

Referring to FIG. 3, the voltage obtaining unit 110 may obtain voltage $V_{cellN, cycleM}$ of each of a plurality of battery cells cell1, cell2, ..., cellN in a plurality of cycles cycle1, cycle2, ..., cycleM. Herein, a cycle may include at least one of a charging cycle in which a battery cell is charged and a discharging cycle in which the battery cell is discharged. Although two cycles are shown in FIG. 3 for convenience of a description, the plurality of cycles may include M (M is an integer of at least 2) cycles. According to an embodiment, the plurality of cycles may include, but not limited to, 10 or more cycles or 20 or more cycles. As the number of cycles increases, the battery management apparatus 100 may clearly analyze a trend of a long-term voltage behavior over a plurality of cycles and reduce a diagnosis error when diagnosing an abnormal battery cell.

According to an embodiment, each of the plurality of cycles may include a period between a charging start point A and a discharging start point C of a battery cell. In another aspect, the cycle may include a charging period A to B and a rest period B to C after charging. Thus, the battery management apparatus 100 may analyze a voltage behavior in the charging period A to B and the rest period B to C before discharging based on a voltage obtained in the plurality of cycles. In this way, the battery management apparatus 100 may detect an abnormal behavior of a voltage, related to a capacity change of a battery cell in the charging period A to B and the rest period B to C after the charging period instead of analyzing a voltage behavior in a discharging period C to D and a rest period (not shown) after the discharging period, thereby detecting an abnormal battery cell.

Referring back to FIG. 2, the controller 120 may control operations of the battery management apparatus 100. The controller 120 may manage each of the plurality of battery cells. According to an embodiment, the controller 120 may analyze a voltage behavior based on voltage data of each of the plurality of battery cells 10, obtained from the voltage obtaining unit 110, to determine whether each of the plurality of battery cells 10 is abnormal and diagnose a state.

According to an embodiment, when it is determined that the battery cell has abnormality as a result of diagnosis, the controller 120 may provide information about the abnormal battery cell to a user. For example, the controller 120 may provide information about an abnormal battery cell to a user terminal through a communication circuit (not shown) and provide the information about the abnormal battery cell through a display provided in a vehicle, a charger, etc.

According to an embodiment, the battery management apparatus 100 may calculate a value related to a voltage behavior of a battery cell to analyze a trend of the voltage behavior of the battery cell. Herein, the trend may mean a continuous and consistent directivity of time-series data over time. The value related to the voltage behavior of the battery cell may include a first value, a second value, and time-series data of the second value. According to an embodiment, the controller 120 may calculate a first value regarding a voltage behavior of each of the plurality of battery cells 10 in each of the plurality of cycles, a second value obtained by normalizing the first value of each of the plurality of battery cells 10, and time-series data in which the second value of each of the plurality of battery cells 10 is arranged during the plurality of cycles.

Referring to FIG. 3, the controller 120 may calculate the first value regarding a voltage behavior of each of the plurality of battery cells cell1, cell2, ..., cellN in each of the plurality of cycles cycle1, cycle2, ..., cycleM, based on voltage data obtained in the plurality of cycles cycle1, cycle2, ..., cycleM. Herein, the first value may mean an indicator indicating a voltage behavior of a battery cell in a first cycle (e.g., cycle1) including the charging period A to B and the rest period B to C after charging.

According to an embodiment, the controller 120 may calculate the first value based on a voltage change of the battery cell in the charging period A to B and the rest period B to C after charging. Herein, the charging period A to B and the rest period B to C after charging may include the charging start point A, a charging end point B, and the discharging start point C.

According to an embodiment, the controller 120 may calculate a first vector, a second vector, and a third vector indicating voltage behaviors between different two points among the charging start point A, the charging end point B, and the discharging start point C. The controller 120 may calculate the first value that is a scalar value by preprocessing the first vector, the second vector, and the third vector. Herein, the controller 120 may calculate a vector having the charging start point A as a start point and the charging end point B as an end point as a first vector v1, a vector having the charging start point A as a start point and the discharging start point C as an end point as a second vector v2, and a vector having the charging end point B as a start point and the discharging start point C as an end point as a third vector v3.

For example, the controller 120 may calculate, in the first cycle cycle 1 of the first battery cell cell1, a first vector $v1_{cell1,cycle1}$, a second vector $v2_{cell1,cycle1}$, and a third vector $v3_{cell1,cycle1}$ as shown in FIG. 3.

According to an embodiment, the controller 120 may determine a random point between the charging period A to B as the start points of the first vector v1 and the second vector v2. For example, the controller 120 may determine a point at which the voltage of the battery cell is a specific voltage (e.g., 0.5 V) as the start points of the first vector v1 and the second vector v2. For example, the controller 120 may determine a point at which the SOC of the battery cell is a specific SOC (e.g., 10 %) as the start points of the first vector v1 and the second vector v2. In this way, the controller 120 may calculate the voltage behavior of the battery cell by amending degradation and deterioration of each of the plurality of battery cells 10.

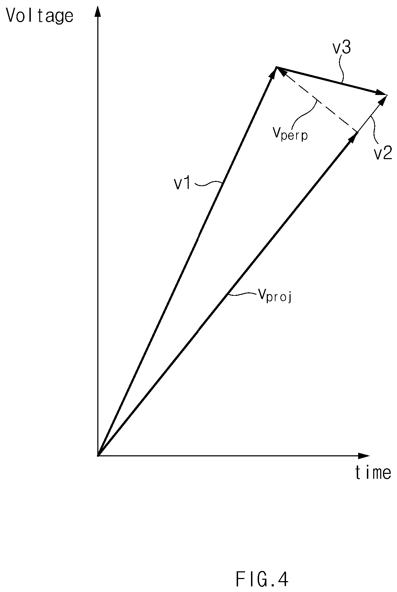

FIG. 4 is a graph showing a process of calculating a first value according to an embodiment disclosed herein.

Referring to FIG. 4, the controller 120 may calculate the first voltage by preprocessing the first vector v1, the second vector v2, and the third vector v3. Herein, preprocessing may mean a process of calculating three vectors v1, v2, and v3 to derive the first value that is a component of the trend of the voltage behavior, and the first value may mean a scalar value. Through such a preprocessing process, the controller 120 may calculate the first value indicating a geometric relationship among the first vector v1, the second vector v2, and the third vector v3. Thus, the controller 120 may calculate the first value that is an indicator of the voltage behavior of the battery cell between the charging period A to B and the rest period B to C after charging.

According to an embodiment, preprocessing of the controller 120 may include next first to third preprocessing operations. According to an embodiment, the controller 120 may calculate a projection vector $v_{proj}$ by projecting the first vector v1 to the second vector v2 in the first preprocessing operation. For example, the controller 120 may calculate the projection vector $v_{proj}$ based on Equation 1 provided below.

【Equation 1】

$$v_{proj} = \frac{v1 \cdot v2}{\|v2\|} \times v2$$

In Equation 1, v1 indicates a first vector, v2 indicates a second vector, and $v_{proj}$ indicates a projection

vector obtained by projecting the first vector to the second vector.

According to an embodiment, the controller 120 may calculate a perpendicular vector $v_{perp}$ that is a difference between the first vector v1 and the projection vector $v_{proj}$ in the second preprocessing operation.

For example, the controller 120 may calculate the perpendicular vector $v_{perp}$ based on Equation 2 provided below.

【Equation 2】

$$v_{perp} = v1 - v_{proj}$$

In Equation 2, v1 indicates the first vector, $v_{proj}$ indicates the projection vector, and $v_{perp}$ indicates the perpendicular vector.

According to an embodiment, the controller 120 may calculate a size of a vector calculated by projecting the third vector v3 to the perpendicular vector $v_{perp}$ in the third preprocessing operation, thereby calculating the first value.

For example, the controller 120 may calculate the first value based on Equation 3 provided below.

【Equation 3】

$$First\ Value = \frac{v3 \cdot v_{perp}}{v_{perp}}$$

In Equation 3, v3 indicates the third vector and $v_{perp}$ indicates the perpendicular vector. Thus, the controller 120 may calculate the first value indicating the geometric relationship among the first vector v1, the second vector v2, and the third vector v3 through the first to third preprocessing operations. Thus, the controller 120 may calculate the first value that is an indicator of the voltage behavior of the battery cell between the charging period A to B and the rest period B to C after charging.

According to an embodiment, the controller 120 may calculate the first value of each of the plurality of battery cells (e.g., cell1, cell2, ..., cellN) in each cycle. In another aspect, the controller 120 may calculate the first value of the first battery cell cell1, the first value of the second battery cell cell2, ..., the first value of the $N^{th}$ battery cell cellN in an $M^{th}$ cycle cycleM. Thus, there may be as many first value calculated in the $M^{th}$ cycle cycleM as the number of battery cells (e.g., N). The N first values calculated in the $M^{th}$ cycle cycleM may have different ranges (or scales). Thus, the controller 120 may standardize the ranges (or scales) of the first values by normalizing the first values in each of the plurality of cycles.

According to an embodiment, the controller 120 may calculate a second value by normalizing the first values in each of the plurality of cycles. Herein, the controller 120 may normalize the first value based on the average and the standard deviation of the first values in each of the plurality of cycles. According to an embodiment, the controller 120 may calculate the average and the standard deviation of N first values calculated in the first cycle cycle1. The controller 120 may calculate the second value of each of the plurality of battery cells (e.g., cell1, cell2, ..., cellN) by dividing a difference between the first value of each of the plurality of battery cells (e.g., cell1, cell2, ..., cellN) and the average thereof by the standard deviation. In this way, the controller 120 may detect an abnormal battery cell by converting the first values of different ranges (or scales) into similar scales.

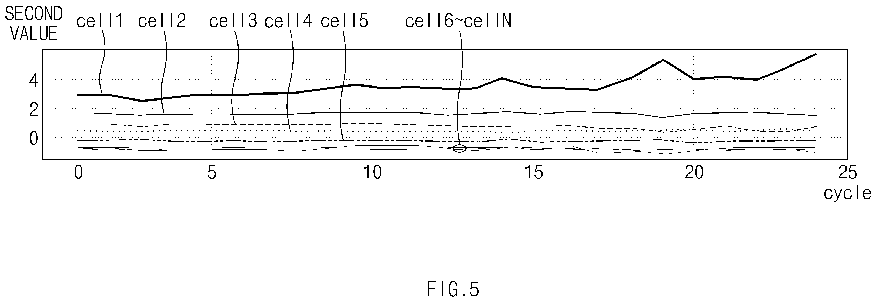

FIG. 5 is a view showing time-series data of a second value according to an embodiment disclosed herein.

Referring to FIG. 5, the controller 120 may calculate time-series data of the second value of each of the plurality of battery cells cell1, cell2, ..., cellN in the plurality of cycles cycle 1, cycle2, ..., cycleM. Herein, time-series data of a battery cell (e.g., cellN) may mean data expressing the second value of the battery cell (e.g., cellN)in the plurality of cycles cycle1, cycle2, ..., cycleM with a function.

For example, the graph shown in FIG. 5 may be a function indicating the time-series data of the second value of each of the plurality of battery cells (e.g., cell1, cell2, ..., cellN). Herein, in the graph, an x axis may mean a cycle (unit, the number of times), and a y axis may mean a second value. According to an embodiment, as shown in FIG. 5, as the number of cycles increases, a trend between the time-series data of the second value irregularly changes to a greater deviation. Thus, the controller 120 may more accurately detect an abnormal battery cell by calculating the time-series data of the second value based on the voltage data obtained in a more number of cycles.

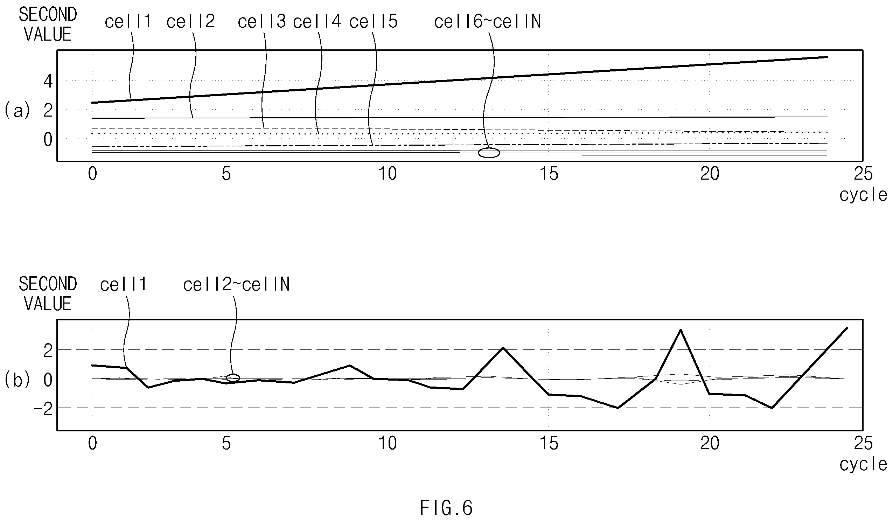

FIG. 6 is a graph showing a result of analyzing a trend of time-series data of a second value according to an embodiment disclosed herein.

Referring to FIG. 6, the controller 120 may analyze a trend of time-series data of the plurality of battery cells cell1, cell2, ..., cellN to detect an abnormal battery cell. Herein, the trend may mean a continuous and consistent directivity of time-series data. According to an embodiment, the controller 120 may analyze a trend of the time-series data through time-series data decomposition. For example, the controller 120 may separate the time-series data into a trend component and a remaining (or residual) component through various time-series data decomposition methods. In this way, the controller 120 may separately analyze the trend component and the remaining component of time-series data of the plurality of battery cells cellI, cell2, ..., cellN and detect a (normal or abnormal) state of the battery cells.

According to an embodiment, the controller 120 may decompose the time-series data of the second value of each of the plurality of battery cells cell1, cell2, ..., cellN into a trend component a and a remaining component b based on at least one of a Hodrick-Prescott (HP) filter and a Baxter-King (BK) filter. For example, the controller 120 may decompose the time-series data of the second value into the trend component a and the remaining component b shown in FIG. 6 by applying the HP filter to the time-series data of the second value shown in FIG. 5.

According to an embodiment, the trend component a may indicate a long-term tendency (e.g., increase, decrease, etc.) of the time-series data of the second value, and the remaining component b may indicate a tendency (e.g., a periodic tendency, noise, or random change, etc.) except for a long-term tendency in the time-series data of the second value. Thus, the controller 120 may detect a specific voltage change of the abnormal battery cell in terms of a long-term voltage behavior by analyzing the remaining component b of the time-series data of the second value.

According to an embodiment, the controller 120 may detect an abnormal battery cell based on the remaining component b of each of the plurality of battery cells cell1, cell2, ..., cellN. According to an embodiment, the controller 120 may compare a magnitude of the remaining component b with a first threshold value. Herein, the first threshold value may mean a reference value for distinguishing an abnormal battery cell from a normal battery cell. According to the specifications of a battery cell and a detection degree of an abnormal cell, the controller 120 may set the first threshold value. According to an embodiment, the first threshold value may be, but not limited to, at least 1 or at least 2. According to an embodiment, as the controller 120 sets the first threshold value to be greater, the controller 120 may detect a battery cell having a more serious abnormal state.

According to an embodiment, when the magnitude of the remaining component b exceeds the first threshold value, the controller 120 may detect the battery cell corresponding to the remaining component b as an abnormal battery cell. For example, when the controller 120 sets the first threshold value to 2, the controller 120 may detect, as an abnormal battery cell, a battery cell (e.g., cell1) having the remaining component b exceeding 2 or being less than -2. In this way, the controller 120 may detect the abnormal battery cell in terms of a long-term voltage behavior based on the remaining component b of the time-series data of the second value of the plurality of battery cells cell1, cell2, ..., cellN.

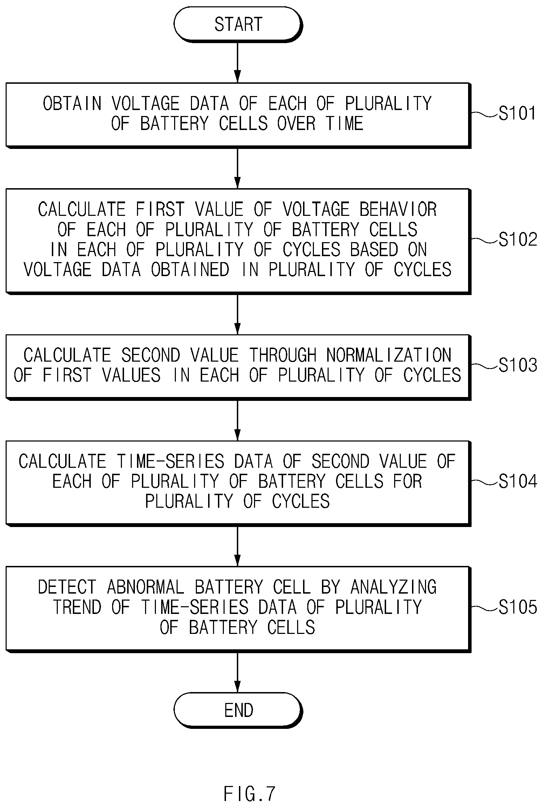

FIG. 7 is a flowchart showing an operation of a battery management apparatus according to an embodiment disclosed herein.

Referring to FIG. 7, the battery management apparatus 100 may obtain voltage data of each of a plurality of battery cells over time in operation S101, calculate a first value regarding a voltage behavior of each of the plurality of battery cells in each of a plurality of cycles based on the voltage data obtained in the plurality of cycles in operation S102, calculate a second value through normalization of the first values in each of the plurality of cycles in operation S103, calculate time-series data of the second value of each of the plurality of battery cells for the plurality of cycles in operation S104, and detect an abnormal battery cell by analyzing a trend of the time-series data of the plurality of battery cells in operation S105.

In operation S101, the data obtaining unit 110 of the battery management apparatus 100 may obtain the voltage data of each of the plurality of battery cells over time.

In operation S102, the controller 120 of the battery management apparatus 100 may calculate a first value regarding a voltage behavior of each of the plurality of battery cells in each of the plurality of cycles based on the voltage data obtained in the plurality of cycles. According to an embodiment, the controller 120 may calculate a first vector, a second vector, and a third vector indicating voltage behaviors between different two points among the charging start point A, the charging end point B, and the discharging start point C. The controller 120 may calculate the first value that is a scalar value by preprocessing the first vector, the second vector, and the third vector.

According to an embodiment, preprocessing by the controller 120 may include calculating a projection vector by projecting the first vector to the second vector, calculating a perpendicular vector that is a difference between the first vector and the projection vector, and calculating the first value that is a size of a vector calculated by projecting the third vector to the perpendicular vector.

In operation S103, the controller 120 may calculate a second value by normalizing the first values in each of the plurality of cycles. Herein, the controller 120 may normalize the first value based on the average and the standard deviation of the first values in each of the plurality of cycles.

In operation S104, the controller 120 may calculate time-series data of the second value of each of the plurality of battery cells for the plurality of cycles.

In operation S105, the controller 120 may detect an abnormal battery cell by analyzing a trend of the time-series data of the plurality of battery cells. According to an embodiment, the controller 120 may decompose the time-series data of the second value of each of the plurality of battery cells cell1, cell2, ..., cellN into a trend component a and a remaining component b based on a time-series data decomposition method. The controller 120 may detect an abnormal battery cell based on the remaining component of each of the plurality of battery cells cell1, cell2, ..., cellN.

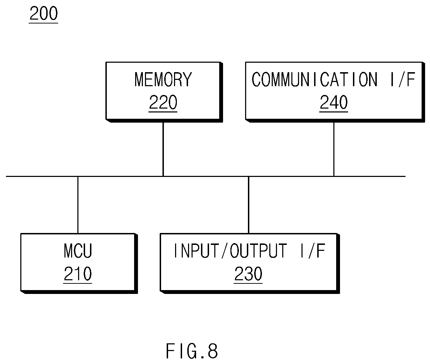

FIG. 8 is a block diagram showing a hardware configuration of a computing system for performing an operating method of a battery management apparatus, according to an embodiment disclosed herein.

Referring to FIG. 8, a computing device 200 according to an embodiment disclosed herein may include a microcontroller unit (MCU) 210, a memory 220, an input/output interface (I/F) 230, and a communication I/F 240.

The MCU 210 may be a processor that executes various programs (e.g., a battery cell data collection program, a graph calculation program, a data analysis program, a data decomposition algorithm, a normalization program, a battery cell diagnosis program, etc.) stored in the memory 220, processes various information including feature data, potential variables, etc., of the battery cell through these programs, and executes the above-described functions of the controller included in the battery management apparatus 100 shown in FIGS. 1 to 7.

The memory 220 may store various programs such as a battery cell data collection program, a graph calculation program, a data analysis program, a data decomposition algorithm, a normalization program, a battery cell diagnosis program, etc.

The memory 220 may be provided in plural, depending on a need. The memory 220 may be a volatile or nonvolatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 210.

The communication I/F 240, which is a component capable of transmitting and receiving various data to and from a server, may be various devices capable of supporting wired or wireless communication. For example, the battery management apparatus 100 may transmit and receive various information including a shape model, etc., of the battery cell from an external server separately provided through the communication I/F 240.

As such, a computer program according to an embodiment disclosed herein may be recorded in the memory 220 and processed by the MCU 210, thus being implemented as a module that performs functions shown in FIG. 2.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure, and various changes, substitutions, and modifications may be made herein without departing from the scope of the present disclosure.

**List of Reference Numerals for Major Elements**

    1: BATTERY PACK
    2: HIGHER-LEVEL CONTROLLER
    10: PLURALITY OF BATTERY CELLS
    12: BATTERY CELL
    14: SENSOR UNIT
    16: SWITCHING UNIT
    20: BMS
    100: BATTERY MANAGEMENT APPARATUS
    110: INFORMATION OBTAINING UNIT
    120: CONTROLLER
    200: COMPUTING SYSTEM
    210: MCU
    220: MEMORY
    230: INPUT/OUTPUT I/F
    240: COMMUNICATION I/F

**Claims**

1. A battery management apparatus comprising:

    a voltage obtaining unit configured to obtain voltage data of each of a plurality of battery cells over time; and
    a controller configured to:

    calculate a first value regarding a voltage behavior of each of the plurality of battery cells in each of a plurality of cycles based on the voltage data obtained in the plurality of cycles;
    calculate a second value through normalization of the first values in each of the plurality of cycles;
    calculate time-series data of the second value of each of the plurality of battery cells for the plurality of cycles; and
    analyze a trend of time-series data of the plurality of battery cells to detect an abnormal battery cell.

2. The battery management apparatus of claim 1, wherein each of the plurality of cycles comprises a period between a charging start point and a discharging start point of the plurality of battery cells.

3. The battery management apparatus of claim 1, wherein the controller is further configured to:

    calculate a first vector, a second vector, and a third vector indicating a voltage behavior between two different points among a charging start point, a charging end point, and a discharging start point of each of the plurality of battery cells; and
    calculate the first value, which is a scalar value, by preprocessing the first vector, the second vector, and the third vector.

4. The battery management apparatus of claim 3, wherein a start point of the first vector is the charging start point and an end point of the first vector is the charging end point,

    a start point of the second vector is the charging start point and an end point of the second vector is the discharging start point, and
    a start point of the third vector is the charging end point and an end point of the third vector is the discharging start point.

5. The battery management apparatus of claim 4, wherein
the controller is further configured to:

    calculate a projection vector by projecting the first vector to the second vector;
    calculate a perpendicular vector that is a difference between the first vector and the projection vector; and
    calculate the first value that is a size of a vector calculated by projecting the third vector to the perpendicular vector.

6. The battery management apparatus of claim 1, wherein the controller is further configured to calculate the second value by normalizing the first value based on an average and a standard deviation of the first values in each of the plurality of cycles.

7. The battery management apparatus of claim 1, wherein the controller is further configured to decompose time-series data of the second value of each of the plurality of battery cells into a trend component and a remaining component based on at least one of a Hodrick-Prescott (HP) filter and a Baxter-King (BK) filter.

8. The battery management apparatus of claim 7, wherein the controller is further configured to detect the abnormal battery cell based on a magnitude of the remaining component of each of the plurality of battery cells.

9. The battery management apparatus of claim 8, wherein the controller is further configured to compare a magnitude of the remaining component with a first threshold value and detect a battery cell corresponding to the remaining component as an abnormal battery cell when the magnitude of the remaining component exceeds the first threshold value.

10. An operating method of a battery management apparatus, the operating method comprising:

    obtaining voltage data of each of a plurality of battery cells over time;
    calculating a first value regarding a voltage behavior of each of the plurality of battery cells in each of a plurality of cycles based on the voltage data obtained in the plurality of cycles;
    calculating a second value through normalization of the first values in each of the plurality of cycles;
    calculating time-series data of the second value of each of the plurality of battery cells for the plurality of cycles; and
    analyzing a trend of time-series data of the plurality of battery cells to detect an abnormal battery cell.

11. The operating method of claim 10, wherein each of the plurality of cycles comprises a period between a charging start point and a discharging start point of the plurality of battery cells.

12. The operating method of claim 10, wherein the calculating of the first value comprises:

    calculating a first vector, a second vector, and a third vector indicating a voltage behavior between two different points among a charging start point, a charging end point, and a discharging start point of each of the plurality of battery cells; and
    calculating the first value, which is a scalar value, by preprocessing the first vector, the second vector, and the third vector.

13. The operating method of claim 12, wherein a start point of the first vector is the charging start point and an end point of the first vector is the charging end point,

    a start point of the second vector is the charging start point and an end point of the second vector is the discharging start point, and
    a start point of the third vector is the charging end point and an end point of the third vector is the discharging start point.

14. The operating method of claim 13, wherein the preprocessing comprises:

    calculating a projection vector by projecting the first vector to the second vector;
    calculating a perpendicular vector that is a difference between the first vector and the projection vector; and
    calculating the first value that is a size of a vector calculated by projecting the third vector to the perpendicular vector.

15. The operating method of claim 10, wherein the calculating of the second value comprises calculating the second value by normalizing the first value based on an average and a standard deviation of the first values in each of the plurality of cycles..

16. The operating method of claim 10, wherein the analyzing of the trend of the time-series data of the plurality of battery cells comprises decomposing time-series data of the second value of each of the plurality of battery cells into a trend component and a remaining component based on at least one of a Hodrick-Prescott (HP) filter and a Baxter-King (BK) filter.

17. The operating method of claim 16, wherein the detecting of the abnormal battery cell comprises detecting the abnormal battery cell based on a magnitude of the remaining component of each of the plurality of battery cells.

18. The operating method of claim 17, wherein the detecting of the abnormal battery cell comprises comparing a magnitude of the remaining component with a first threshold value and detecting a battery cell corresponding to the remaining component as an abnormal battery cell when the magnitude of the

**EP 4 768 970 A1**

remaining component exceeds the first threshold value.

FIG.1

BATTERY MANAGEMENT APPARATUS
100

VOLTAGE OBTAINING UNIT
110

CONTROLLER
120

FIG.2

Voltage cell1

B

v3$_{cell1,cycle1}$

v1$_{cell1,cycle1}$

C

v2$_{cell1,cycle1}$

V$_{cell1,cycle1}$

V$_{cell1,cycle2}$

A

D

cycle1

cycle2

time

FIG.3

FIG.4

FIG.5

SECOND VALUE

cell1  cell2    cell3 cell4 cell5      cell6~cellN

(a)

SECOND VALUE

cell1      cell2~cellN

(b)

FIG.6

```
                    ┌─────────────┐
                    │    START    │
                    └──────┬──────┘
                           │
                           ▼
        ┌──────────────────────────────────────┐
        │ OBTAIN VOLTAGE DATA OF EACH OF PLURALITY │──S101
        │     OF BATTERY CELLS OVER TIME         │
        └──────────────────┬───────────────────┘
                           │
                           ▼
        ┌──────────────────────────────────────┐
        │ CALCULATE FIRST VALUE OF VOLTAGE BEHAVIOR│
        │   OF EACH OF PLURALITY OF BATTERY CELLS │──S102
        │   IN EACH OF PLURALITY OF CYCLES BASED ON│
        │ VOLTAGE DATA OBTAINED IN PLURALITY OF CYCLES│
        └──────────────────┬───────────────────┘
                           │
                           ▼
        ┌──────────────────────────────────────┐
        │ CALCULATE SECOND VALUE THROUGH NORMALIZATION│──S103
        │ OF FIRST VALUES IN EACH OF PLURALITY OF CYCLES│
        └──────────────────┬───────────────────┘
                           │
                           ▼
        ┌──────────────────────────────────────┐
        │ CALCULATE TIME-SERIES DATA OF SECOND VALUE OF│
        │   EACH OF PLURALITY OF BATTERY CELLS FOR │──S104
        │         PLURALITY OF CYCLES            │
        └──────────────────┬───────────────────┘
                           │
                           ▼
        ┌──────────────────────────────────────┐
        │ DETECT ABNORMAL BATTERY CELL BY ANALYZING│
        │  TREND OF TIME-SERIES DATA OF PLURALITY │──S105
        │         OF BATTERY CELLS               │
        └──────────────────┬───────────────────┘
                           │
                           ▼
                    ┌─────────────┐
                    │     END     │
                    └─────────────┘
```

FIG.7

200

```
┌─────────────┐   ┌────────────────────┐
│   MEMORY    │   │ COMMUNICATION I/F  │
│    220      │   │        240         │
└──────┬──────┘   └─────────┬──────────┘
       │                    │
───────┴────────────────────┴──────────
   │                    │
┌──┴──────────┐   ┌──────┴─────────────┐
│    MCU      │   │  INPUT/OUTPUT I/F  │
│    210      │   │        230         │
└─────────────┘   └────────────────────┘
```

FIG.8

**EP 4 768 970 A1**

## INTERNATIONAL SEARCH REPORT

International application No.

**PCT/KR2024/019359**

| A. | CLASSIFICATION OF SUBJECT MATTER |
|---|---|

**G01R 31/396**(2019.01)i; **G01R 31/3835**(2019.01)i; **G01R 31/392**(2019.01)i; **G01R 31/367**(2019.01)i; **G01R 19/165**(2006.01)i

According to International Patent Classification (IPC) or to both national classification and IPC

| B. | FIELDS SEARCHED |
|---|---|

Minimum documentation searched (classification system followed by classification symbols)

G01R 31/396(2019.01); G01R 19/00(2006.01); G01R 31/367(2019.01); G06N 3/08(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 전압(voltage), 시계열(time series), 추세(trend), 벡터 (vector)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2023-0161377 A (LG ENERGY SOLUTION, LTD.) 27 November 2023 (2023-11-27) See claims 1-5 and figures 3-7. | 1,2,6-11,15-18 |
| A | | 3-5,12-14 |
| Y | KR 10-2021-0071161 A (DONGGUK UNIVERSITY INDUSTRY-ACADEMIC COOPERATION FOUNDATION) 16 June 2021 (2021-06-16) See paragraph [0060] and claims 1-6. | 1,2,6-11,15-18 |
| A | KR 10-2022-0074797 A (LG ENERGY SOLUTION, LTD.) 03 June 2022 (2022-06-03) See claims 1-20 and figures 1-7. | 1-18 |
| A | KR 10-2023-0153096 A (SAMSUNG SDI CO., LTD. et al.) 06 November 2023 (2023-11-06) See paragraphs [0058]-[0061] and claims 1-3. | 1-18 |

| ☑ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 March 2025** | **07 March 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/019359**

| C. | DOCUMENTS CONSIDERED TO BE RELEVANT | |
|---|---|---|
| Category* | Citation of document, with indication, where appropriate, of the relevant passages | Relevant to claim No. |
| A | JP 2022-151025 A (YAZAKI CORP.) 07 October 2022 (2022-10-07)<br>See paragraphs [0040]-[0046] and claims 1-4. | 1-18 |

Form PCT/ISA/210 (second sheet) (July 2022)

**INTERNATIONAL SEARCH REPORT**
Information on patent family members

International application No.

**PCT/KR2024/019359**

| Patent document cited in search report | | | Publication date (day/month/year) | Patent family member(s) | | | Publication date (day/month/year) |
|---|---|---|---|---|---|---|---|
| KR | 10-2023-0161377 | A | 27 November 2023 | CN | 119110904 | A | 10 December 2024 |
| | | | | EP | 4484982 | A1 | 01 January 2025 |
| | | | | JP | 2025-502294 | A | 24 January 2025 |
| | | | | WO | 2023-224414 | A1 | 23 November 2023 |
| KR | 10-2021-0071161 | A | 16 June 2021 | KR | 10-2297543 | B1 | 02 September 2021 |
| KR | 10-2022-0074797 | A | 03 June 2022 | CN | 115461634 | A | 09 December 2022 |
| | | | | EP | 4152021 | A1 | 22 March 2023 |
| | | | | JP | 2023-519949 | A | 15 May 2023 |
| | | | | JP | 2024-099795 | A | 25 July 2024 |
| | | | | JP | 7483922 | B2 | 15 May 2024 |
| | | | | KR | 10-2024-0109971 | A | 12 July 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2023-0153096 | A | 06 November 2023 | CN | 116973756 | A | 31 October 2023 |
| | | | | EP | 4270033 | A1 | 01 November 2023 |
| | | | | KR | 10-2756746 | B1 | 21 January 2025 |
| | | | | US | 2023-0349977 | A1 | 02 November 2023 |
| JP | 2022-151025 | A | 07 October 2022 | JP | 7620466 | B2 | 23 January 2025 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240021752